# EUROPEAN PATENT SPECIFICATION

(11) **EP 0 630 045 B1**
(45) Date of publication and mention of the grant of the patent: **06.03.2002**
(21) Application number: 94304277.0
(22) Date of filing: 14.06.1994
(51) Int. Cl.: H01L 23/373, H01L 23/367

(54) **Process for the production of a finned diamond heatsink**
Verfahren zur Herstellung von mit Rippen versehener Diamant-Wärmesenke
Procédé de fabrication d'un dissipateur de chaleur à ailettes en diamant

(30) Priority: 14.06.1993 JP 14169193; 30.06.1993 JP 16209393
(43) Date of publication of application: 21.12.1994
(60) Divisional application: 00113231.5
(73) Proprietor: SUMITOMO ELECTRIC INDUSTRIES, LIMITED, Osaka 541 (JP)
(72) Inventor: Yamamoto, Yoshiyuki, c/o Itami Works of Sumitomo, Itami-shi, Hyogo (JP); Tsuno, Takashi, c/o Itami Works of Sumitomo, Itami-shi, Hyogo (JP); Imai, Takahiro, c/o Itami Works of Sumitomo, Itami-shi, Hyogo (JP); Fujimori, Naoji, c/o Itami Works of Sumitomo, Itami-shi, Hyogo (JP)
(74) Representative: Allard, Susan Joyce

(56) References cited:
- EP-A- 0 142 282
- GB-A- 2 256 526
- US-A- 4 964 458
- PROCEEDINGS OF THE SEVENTH IEEE SEMICONDUCTOR THERMAL MEASUREMENT AND MANAGEMENT SYMPOSIUM, February 1991, NEW YORK , US pages 59 - 63 G.M.HARPOLE ET AL. 'Micro-channel heat exchanger optimization'
- PATENT ABSTRACTS OF JAPAN vol. 7, no. 45 (E-160) (1190) 23 February 1983 & JP-A-57 196 552 (NIPPON DENKI) 2 December 1982
- JOURNAL OF THE ELECTROCHEMICAL SOCIETY, vol.138, no.6, June 1991, MANCHESTER, NEW HAMPSHIRE US pages 1706 - 1709 R.RAMESHAM ET AL. 'Fabrication of microchannels in synthetic polycrystalline diamond thin films for heat sinking applications'
- PATENT ABSTRACTS OF JAPAN vol. 017, no. 225 (C-1055) 10 May 1993 & JP 04 362 096 A (TOSHIBA CORP) 15 December 1992

## Description

This invention relates to a process for the production of a heat sink,and in particular, of a diamond heat sink having a very high thermal property, used for the radiation of semiconductor devices or compressors.

With the miniaturization and increase of processing speed of information processing systems, the processing capacity per unit area of semiconductor devices incorporated into the system is rapidly increasing. This results in an increase of the quantity of heat generated per unit area in the semiconductor device and the importance of maintaining the thermal properties thereof has been watched with keen interest when designing a substrate on which components are mounted. Up to the present time, a number of combinations of alumina substrates and metallic heat sinks with fins have been used, but because of the low heat conductivity (0.29 W/cm · K) of alumina, sufficient thermal properties cannot be obtained even in combination with the metallic heat sink.

The requirements for the thermal properties of a package on which semiconductor devices are mounted have become more severe because of the increase of the heating generated with the high effectiveness of the devices mounted on the package. Thus, as a means for lowering the heat resistance of the package, for example, it has hitherto been suggested to employ a higher heat conductivity material or to improve convection and heat conduction by forced air cooling, forced water cooling, etc.

As a heat sink material for semiconductor devices having high thermal properties, it has been proposed to use diamond, cubic boron nitride (CBN), aluminum nitride, etc. However, these high heat conductivity materials have the disadvantage that although their heat conductivity is higher than that of alumina, etc., their production cost is higher. In particular, diamond is proposed as a heat sink for semiconductors, since the gaseous phase synthesis technique has recently been developed and progressed and a sheet-shaped diamond substrate with a large surface are can be obtained. However, diamond is much more expensive than the ordinary materials of the prior art and its high heat conductivity cannot effectively be utilized, since fin-fitted diamond sheets cannot be prepared and the joint use of a metallic fin-fitted heat sink is required.

The ordinary materials used for the package, for example, alumina will meet with problems regarding thermal properties when a higher performance device is put to practical use in the near future. It is believed that a problem will arise in that the heat resistance of the known packages will be so large that the heat generated by the device itself cannot sufficiently be radiated to raise the temperature of the device and the device fails to function normally. In order to solve this problem, a high heat conductivity material may be used, as described above, and diamond having the highest heat conductivity, of the prevailing materials, has been used as a semiconductor laser diode. At the present time, as the diamond for radiation, natural diamond single crystal or artificial diamond single crystal prepared by a high pressure synthesis method and polycrystal prepared by a gaseous phase synthesis method are used, but they are generally limited to plate-shaped crystals. However, the heat transferred by a heat sink should finally be discharged through a fluid such as air or cooling water, and a structure with a large radiation area, such as fin-fitted heat sinks, are preferred for improving the heat exchange function with such a fluid.

GB-A-2 256 526 relates to an embedded diamond heat sink wherein diamond is provided in holes or recesses in a silicon substrate and a CVD diamond layer is deposited on this structure. Journal of the Electrochemical Society 138(1991) June, No. 6, pp. 1706-1709, discloses a process for the formation of microchannels in a polycrystalline diamond thin film on a single-crystal silicon substrate. JP-A-4-362096 discloses a heat sink comprising a substrate and diamond fins projecting therefrom.

We have now developed a process for the production of a diamond heat sink, of a small size, having very high thermal properties, which may be used as a heat sink for mounting semiconductor devices or. compressors.

Accordingly, in a first aspect the present invention provides a process for the production of a heat sink comprising a diamond substrate and fins of diamond projecting therefrom for improving heat dissipation, the fins being spaced apart to define open channels therebetween, which process comprises the steps of:
(a) providing a base material with gaps therein for the insertion of fins;
(b) inserting the fins into the gaps in such a manner that the highest part of the inserted fins and the top surface of the base material are at substantially the same level;
(c) growing diamond on the base material and fins; and
(d) removing the base material to obtain the said diamond heat sink.

According to a second aspect of the present invention, there is provided a process for the production of a heat sink comprising a diamond substrate and fins of diamond projecting therefrom for improving heat dissipation, the fins being spaced apart to define open channels therebetween, which process comprises the steps of:
(a) providing a base material consisting of divided base materials arranged on blocks with gaps for the insertion of fins;
(b) inserting the fins in the gaps of the divided base materials in such a manner that the highest part of the fins and the top surface of the divided base materials are at substantially the same level;
(c) growing diamond on the divided base materials and fins; and
(d) removing the divided base materials to obtain the said diamond heat sink.

The accompanying drawings are to illustrate the principle and merits of the invention in greater detail.

Fig. 1 is a plan view of a heat sink.

Fig. 2 is a sectional view of a heat sink part in a ceramic PGA (Pin Grid Array) package.

Fig. 3 is a sectional view of the heat sink shown in Fig. 2, on which hollows are made.

Fig. 4 is a sectional view of a heat sink.

Fig. 5, a) to d) is a schematic view to illustrate a process for the production of a heat sink, described in Example 2.

Fig. 6, a) to c) is a schematic view to illustrate a process for the production of a heat sink, described in Example 3.

It has been found that the thermal properties are improved more by burying fins consisting of diamond in a base material near to the side where semiconductor devices are mounted on the base material, not by bonding the fins to the surface of the base material.

Thus, the heat resistance can largely be decreased by forming a heat sink having a fin structure consisting of diamond on the radiation surface.

In one embodiment of the first aspect of the present invention, the gaps in the base material consist of grooves formed therein, and wherein the fins are inserted in the grooves, the fins having a height substantially the same as the depth of the grooves, diamond is grown by gaseous phase synthesis on the base material, and the base material is subsequently removed to obtain the said diamond heat sink.

The present invention provides a very simple process for the production of a diamond heat sink having a fin structure by a gaseous phase synthesis method. This process consists in arranging a base material and fins for growing diamond in such a manner that the surface of the base material and the upper end of the fin be substantially the same in height by the use of a suitable supporting member or by working the base material itself and growing diamond thereon by the gaseous phase synthesis method. At the same time, the fin material is not required to be free-standing and is diamond having a heat conductivity of at least 1 W/cmK. The free-standing film is such a film as to have a thickness capable of substantially maintaining a shape as a diamond film even if the base material is removed, and ordinarily have a thickness of about at least 0.1 mm.

The thickness of the diamond heat sink should naturally be at least a thickness capable of free-standing, but if too thick, a long time is taken for the synthesis thereof to be uneconomical, while if too thin, the mechanical strength is lowered. Thus, a thickness of 0.3 mm to 5 mm is preferably used.

As the fin material, it is preferable to use one having a heat conductivity of at least 5 (W/cmK) and polycrystalline diamond by gaseous phase synthesis having a heat conductivity of 8 to 20 (W/cmK) is the most preferable in view of the production cost and property, but high pressure synthesis single crystal diamond (15 to 30 W/cmK) can also be used.

The shape of a fin is such that the thickness is at least 50µm for the purpose of effectively conducting thermal conduction, but a thickness of more than 2 mm is not preferable because of increase of the cost. The height of a fin projected from the substrate should preferably be at least 0.5 mm and effective radiation of heat can be conducted in the range of 2 to 15 mm.

As to the shape of a substrate provided with fins, penetration working is not necessarily required therefore and it is preferable that the fins reach the vicinity of semiconductor devices at least by half of the thickness of the base material. A diamond fin can be obtained by preparing a diamond free-standing film by an ordinary gaseous phase synthesis method and working in a desired shape by the use of a laser. Moreover, high pressure synthesis single crystal diamond can be used if it can be worked in a desired size. Any known procedure can be used in the gaseous synthesis of diamond.

As to the material to be a fin, for example, the free-standing film of gaseous phase synthesis diamond is preferably used because of having a high heat conductivity and being readily obtainable with a large area. Any synthesis method of this film can be used, for example, which comprises growing diamond to a thickness of more than what can be obtained as a free-standing film to what can be used as a fin, and then removing a base material by any of known methods (eg acid treatment). The free-standing film, which will be a fin part of the heat sink, is subjected to cutting working to a size corresponding to the fin, for example, using a laser light.

Since diamond having the highest heat conductivity is used as a main body for transporting heat of a heat sink in the present invention, a high radiation effect can be given, as a whole.

A diamond material having an effect as a fin of the diamond heat sink has a heat conductivity of at least 1 W/cmK at near room temperature and resisting a temperature of 700° C during growth of diamond. This material can also be used as a base material. In particular, such a material that when diamond is grown on the end thereof by gaseous phase synthesis, the bonding property between them can well be maintained is more preferable. Illustrative of which are high pressure synthesis single crystal diamond or natural single crystal diamond, gaseous phase synthesis diamond described above.

Considering thermal property and production efficiency, the shape of the fin should preferably be such that the thickness is 50 µm to 2 mm and the height is at least 2 mm. The interval for fitting the fins is preferably in the range of about 1 to 5 mm, since if too small, the thermal property is remarkably degraded, while if too large, the radiation area is not so large. This range depends on conditions of heat generation of devices to be mounted and air cooling of a package.

The method for producing the diamond heat sink having fins according to the present invention is summarized in a method comprising supporting a diamond material to be fins by a certain means, trueing up the upper ends of the fins and growing diamond thereon by a gaseous phase synthesis method. There are two examples concerning the supporting method, as illustrated below in detail.

The first method comprises using blocks in a suitable interval. That is, blocks made of a material stable in an atmosphere for gaseous phase synthesis of diamond are arranged with gaps in which diamond fins are inserted. The size of the gap is suitably determined depending upon the interval of fitting the fins. Base materials capable of growing diamond by gaseous phase synthesis are spread all over the blocks. The base material should satisfy the requirement that diamond can be grown thereon and thereafter the base material is readily removed. Specifically, polycrystalline silicon is used. During the same time, it is preferable to subject the base material to a scratching treatment so as to readily grow diamond.

The height of a block on which a base material is to be placed should preferably be so that the surface of the divided base material to be placed thereon be the same as or somewhat lower than the height of a fin. After the base material and fins are arranged in this way, diamond is grown by a gaseous phase synthesis method. The gaseous phase synthesis method of diamond is not particularly limited, but in the case of using a hot filament CVD method, for example, a heat sink with a large area can be obtained in relatively easy manner. The thickness to be grown can be adjusted to such an extent that a free-standing film can be obtained. After diamond is grown in a desired thickness, the base material is removed to obtain a diamond heat sink having fins.

The second method comprises using a base material which can be grooved. That is to say, a material is selected capable of satisfying such conditions that diamond can be grown thereon, grooves can be formed thereon and only the material can readily be removed after growth of diamond and subjected to working to insert a fin material, for example, previously prepared diamond free-standing film in predetermined positions. This working method is not particularly limited, but can be applied to any one of base materials which can be worked on the surface thereof with such a precision that the fin material is inserted. When the fin is inserted, it is preferable that the upper end of the fin is the same as or somewhat projected from the surface of the substrate and it is not preferable that it is somewhat lower than the surface of the substrate in the similar manner to the method using the blocks. As the material of the base material used herein, for example, there is polycrystalline silicon.

Furthermore, diamond is spread over a groove-free area of a base material in the similar manner to the method using the blocks and diamond is grown thereon, whereby the step of removing the divided base material can be omitted and the blocks can be reused. In this case, it is also preferable that the relationship between the surface of the diamond spread and the height of the fin is in that the fin is somewhat projected from or is the same as the surface of the diamond. Thus, diamond is grown on the base material having the high heat conductivity fins inserted by a gaseous phase synthesis method. In the case of this method, a scratching treatment of the surface of the base material is also preferably carried out before grooving or before inserting the fins. The diamond grown herein should have such a thickness that a free-standing film can be obtained. After diamond is grown to such an extent that a free-standing film can be obtained, the diamond and base material are taken from on the blocks and the base material is removed. A radiation substrate having diamond fins on the diamond is thus obtained. As a method of removing the base material part, an acid treatment is used.

When using the structure of a heat sink made according to the present invention, there can be obtained a substrate having higher thermal property with a relatively lower cost as compared with the prior art structure substrate. Accordingly, high output and high speed devices can be mounted with a lower cost, which cannot be mounted on substrates using alumina.

Moreover, when using the structure of a diamond heat sink made according to the present invention, the thermal property of the prior art package can large ly be improved and a heat sink can be realized on which high speed and high power consumption devices can be mounted. Furthermore, according to the production process of the present invention, a heat sink having fins using diamond, on which high performance devices can be mounted, can be produced in simple and effective manner.

The following examples are given in order to illustrate some of the features of the present invention in detail without describing the same completely.

### Example 1 (outside the invention)

Diamond was synthesized in a thickness of 1 mm on a polycrystalline Si base material (24 x 24 x 5 mm) by a hot filament CVD method under synthetic conditions of an atmosphere of methane 2 % - H₂, total pressure of 100 Torr (1Torr-133 Pa) and base material temperature of 800 °C. After the diamond (heat conductivity: 14 W/cm · K) was synthesized under these conditions, the base material Si was dissolved in a mixed acid to obtain a diamond free-standing film of 50 x 25 x 1 mm. The grown surface of this free-standing film was then subjected to polishing and mirror-finishing and cut in eight films of 6 x 24 x 1 mm using excimer laser, after which the whole surfaces were metallized in the order of titanium, platinum and gold.

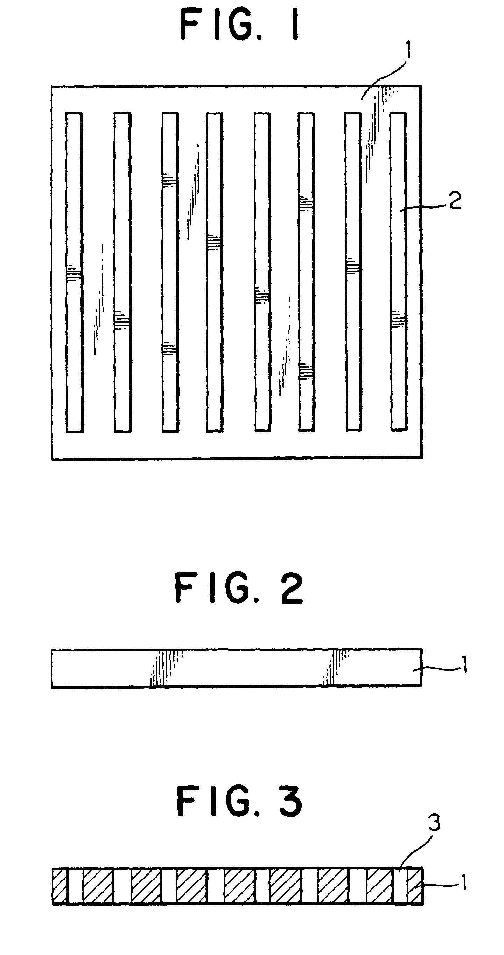

On the other hand, as shown in Fig. 1, a heat sink part 1 (thickness: 2 mm) of an ordinary alumina ceramics PGA package was subjected to laser working to make hollows 3 having a length of 24 mm and width of 1 mm and metallized in the similar manner to described above, in which the above described diamond films as a fin 2 were inserted and bonded by gold-tin brazing. Similarly, another package (not in accordance with the present invention) was prepared using high pressure synthesis polycrystalline cubic boron nitride (heat conductivity: 6.5 W/cm . K) inserted therein.

When the heat resistance of the thus obtained packages was measured under naturally air-cooled state, it was 20 °C/W in the case of using the diamond fin and 26 °C/W in the case of using the cubic boron nitride fin. It was thus confirmed that the heat resistance was decreased to a greater extent as compared with 35 °C/W before fitting the fins and the use of diamond fins was effective for improving the stability of semiconductor devices.

### Example 2 (not in accordance with the present invention)

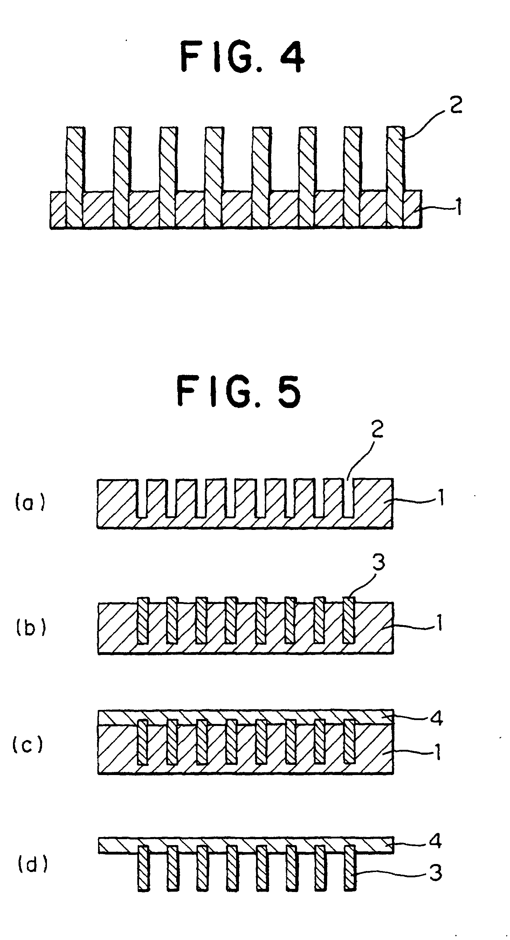

As shown in Fig. 5 a), a polycrystalline Si base material 1 (30 x 30 x 5 mm) was subjected to scratching by the use of diamond abrasive grains and then eight grooves 2 of 24 mm in length, 1 mm in width and 4 mm in depth were formed at an interval of 2 mm. cBN sintered bodies 3 (4 x 24 x 1 mm, 5 W/cm · K) as a fin were inserted in each of the grooves, during which the height of the fin was controlled by inserting a suitable spacer in the groove in such a manner that the upper part of the fin was projected in the range of 50 to 100 µm (Fig. 5 b)). Polycrystalline diamond 4 was grown in a thickness of 1 mm by a hot filament CVD method on the thus resulting polycrystalline Si base material, in which the cBN sintered bodies had been inserted (Fig. 5 c)). The growing conditions were an atmosphere of 2 % CH₄- H₂, total pressure of 100 Torr and base material temperature of 850 °C. The base material Si was then removed by treating with a mixed acid to obtain a diamond heat sink having a size of 30 x 30 x 1 mm and having eight cBN fins each having a size of 24 x 4 x 1 (Fig. 5 d)). The thus obtained heat sink showed a thermal property of 0.8°C/W, measured under forced cooling at 2 m/sec, which was decreased to a greater extent as compared with a heat resistance of 3 °C/W in the case of having no fins.

When using a Cu-W alloy (80 % Cu, 20 % W, 2 W/cm · K) as the fin in this example, the heat sink showed a thermal property of 1.3 °C/W.

### Example 3 (outside the invention)

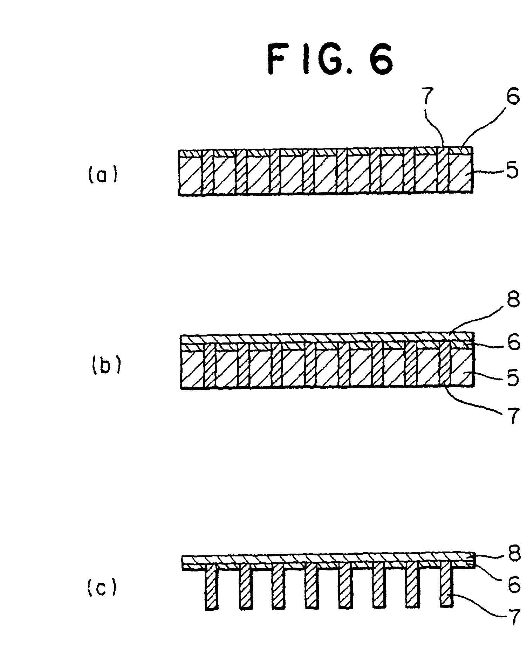

Polycrystalline diamond was grown in a thickness of 600 µm by a hot filament CVD method on a polycrystalline Si base material (25 x 25 x 5 mm) under the same conditions as those of Example 2. After dissolving the base material, the product was subjected to processing by excimer laser to obtain a diamond free-standing film of 2 x 24 x 0.6 mm thickness. On the other hand, a diamond free-standing film to be a fin (15 W/cm · K) was similarly prepared in a thickness of 1 mm and subjected to laser working in 4 x 24 x 1 mm. Then, nine Mo blocks 5 (2 x 25 x 3.5 mm) were prepared and arranged at an interval of 1 mm, in which the previously prepared fins 7 were inserted. The diamond free-standing film of 2 x 24 x 0.6 mm thickness, as divided base materials 6, were placed on the blocks, as shown in Fig. 6 a), during which the height of the diamond surface was lower than that of the fin, but the difference was only at most 50 µm. Diamond 8 was grown in a thickness of 0.4 mm under the same conditions as those of Example 2 on the diamond arranged on the Mo blocks and diamond fins sandwiched therebetween (Fig. 6 b)). After the growth, a diamond heat sink having a size of 26 x 24 x 1 mm and eight diamond fins was obtained (Fig. 6 c)).

## Claims

1. A process for the production of a heat sink comprising a diamond substrate and fins of diamond projecting therefrom for improving heat dissipation, the fins being spaced apart to define open channels therebetween, which process comprises the steps of:
(a) providing a base material with gaps therein for the insertion of fins;
(b) inserting the fins into the gaps in such a manner that the highest part of the inserted fins and the top surface of the base material are at substantially the same level;
(c) growing diamond on the base material and fins; and
(d) removing the base material to obtain the said diamond heat sink.

2. A process for the production of a heat sink comprising a diamond substrate and fins of diamond projecting therefrom for improving heat dissipation, the fins being spaced apart to define open channels therebetween, which process comprises the steps of:
(a) providing a base material consisting of divided base materials arranged on blocks with gaps for the insertion of fins;
(b) inserting the fins in the gaps of the divided base materials in such a manner that the highest part of the fins and the top surface of the divided base materials are at substantially the same level;
(c) growing diamond on the divided base materials and fins; and
(d) removing the divided base materials to obtain the said diamond heat sink.

3. A process as claimed in claim 1, wherein the gaps in the base material consist of grooves formed therein, and wherein the fins are inserted in the grooves, the fins having a height substantially the same as the depth of the grooves, diamond is grown by gaseous phase synthesis on the base material, and the base material is subsequently removed to obtain the said diamond heat sink.

4. A process as claimed in any one of the preceding claims, wherein each fin has a thickness of from 50 µm to 2 mm and a height projecting from the substrate of at least 0.5 mm.

5. A process as claimed in any one of the preceding claims, wherein the fins of diamond have a heat conductivity of at least 1 W/cmK.

6. A process as claimed in claim 5, wherein the diamond has a heat conductivity of at least 5 W/cmK.

7. A process as claimed in any one of the preceding claims, wherein the fins of diamond are buried in the diamond substrate by at least half the depth of the substrate.

8. A process as claimed in any one of the preceding claims, wherein the fins of diamond are gaseous phase synthesised diamond, high pressure synthesised single crystal diamond or natural diamond.

9. A process as claimed in claim 8, wherein the fins of diamond are gaseous phase synthesised polycrystalline diamond having a heat conductivity of 8 to 20 W/cmK or high pressure synthesised single crystal diamond having a heat conductivity of 15 to 30 W/cmK.

## Patentansprüche

1. Verfahren zur Herstellung einer Wärmesenke, umfassend ein Diamantsubstrat und davon abstehende Rippen zum Verbessern der Wärmeverteilung, wobei die Rippen voneinander beabstandet sind, um zwischen diesen offene Kanäle zu definieren, welches Verfahren die Schritte des:
a) Bereitstellens eines Basismaterials mit darin befindlichen Lücken für die Insertion von Rippen;
b) Insertierens der Rippen in die Lücken auf solche Weise, dass sich die höchsten Teile der insertierten Rippen und die obere Oberfläche des Basismaterials im Wesentlichen auf demselben Level befinden;
c) Züchtens von Diamant auf dem Basismaterial und den Rippen; und
d) Entfernens des Basismaterials, um die Diamant-Wärmesenke zu erhalten, umfasst.

2. Verfahren zur Produktion einer Wärmesenke, umfassend ein Diamantsubstrat und davon abstehende Rippen aus Diamant zum Verbessern der Wärmeverteilung, wobei die Rippen voneinander beabstandet sind, um offene Kanäle zwischen diesen zu definieren, welches Verfahren die Schritte des:
a) Bereitstellens eines Basismaterials, bestehend aus zerteilten Basismaterialien, die in Blöcken mit Lücken für die Insertion von Rippen angeordnet sind;
b) Insertierens der Rippen in die Lücken der geteilten Basismaterialien auf solche Weise, dass der höchste Teil der Rippen und die obere Oberfläche der geteilten Basismaterialien sich im Wesentlichen auf demselben Level befinden;
c) Züchtens von Diamant auf den zerteilten Basismaterialien und den Rippen; und
d) Entfernen der zerteilten Basismaterialien, um die Diamant-Wärmesenke zu erhalten, umfasst.

3. Verfahren gemäß Anspruch 1, worin die Lücken in dem Basismaterial aus darin ausgebildeten Kerben bestehen und worin die Rippen in die Kerben insertiert werden, wobei die Rippen eine Höhe im Wesentlichen gleich der Tiefe der Kerben aufweisen, Diamant durch Gasphasensynthese auf dem Basismaterial gezogen wird und das Basismaterial anschließend zum Erhalt der Diamant-Wärmesenke entfernt wird.

4. Verfahren gemäß einem der vorstehenden Ansprüche, worin jede Rippe eine Dicke von 50 µm bis 2 mm und eine Höhe, hervorstehend von dem Substrat, von mindestens 0,5 mm aufweist.

5. Verfahren gemäß einem der vorstehenden Ansprüche, worin die Rippen aus Diamant eine Wärmeleitfähigkeit von mindestens 1 W/cmK haben.

6. Verfahren gemäß Anspruch 5, worin der Diamant eine Wärmeleitfähigkeit von mindestens 5 W/cmK aufweist.

7. Verfahren gemäß einem der vorstehenden Ansprüche, worin die Rippen aus Diamant in dem Diamantsubstrat mindestens zur Hälfte der Tiefe des Substrats versenkt sind.

8. Verfahren gemäß einem der vorstehenden Ansprüche, worin die Rippen aus Diamant in der Gasphase synthetisierter Diamant, hochdrucksynthetisierter Einkristall-Diamant oder natürlicher Diamant sind.

9. Verfahren gemäß Anspruch 8, worin die Rippen aus Diamant in der Gasphase synthetisierter polykristalliner Diamant mit einer Wärmeleitfähigkeit von 8 bis 20 W/cmK oder ein hochdrucksynthetisierter Einkristall-Diamant mit einer Wärmeleitfähigkeit von 15 bis 30 W/cmK sind.

## Revendications

1. Procédé pour la production d'un dissipateur de chaleur comprenant un substrat en diamant et des ailettes en diamant faisant saillie de celui-ci pour améliorer une dissipation de chaleur, les ailettes étant espacées pour définir, entre elles, des canaux ouverts, lequel procédé comprend les étapes, dans lesquelles :
(a) on munit l'intérieur de la matière de base d'espaces pour l'introduction d'ailettes ;
(b) on introduit les ailettes dans les espaces de façon que la partie la plus haute des ailettes introduites et la surface supérieure de la matière de base soient sensiblement au même niveau ;
(c) on fait croître le diamant sur la matière de base et les ailettes ; et
(d) on retire la matière de base pour obtenir ledit dissipateur de chaleur en diamant.

2. Procédé pour la production d'un dissipateur de chaleur comprenant un substrat en diamant et des ailettes en diamant faisant saillie de celui-ci pour améliorer une dissipation de chaleur, les ailettes étant espacées pour définir, entre elles, des canaux ouverts, lequel procédé comprend les étapes, dans lesquelles :
(a) on munit une matière de base, constituée de matières de base séparées agencées en blocs, d'espaces servant à l'introduction d'ailettes ;
(b) on introduit les ailettes dans les espaces des matières de base séparées de façon que la partie la plus haute des ailettes et la surface supérieure des matières de base séparées soient sensiblement au même niveau ;
(c) on fait croître le diamant sur les matières de base séparées et les ailettes ; et
(d) on retire les matières de base séparées pour obtenir ledit dissipateur de chaleur en diamant.

3. Procédé selon la revendication 1, dans lequel les espaces de la matière de base sont constitués de rainures formées dans celle-ci, et dans lequel les ailettes sont introduites dans les rainures, les ailettes ayant une hauteur sensiblement identique à la profondeur des rainures, le diamant fait l'objet d'une croissance par synthèse en phase gazeuse sur la matière de base, et la matière de base est retirée ultérieurement pour obtenir ledit dissipateur de chaleur en diamant.

4. Procédé selon l'une quelconque des revendications précédentes, dans lequel chaque ailette a une épaisseur de 50 µm à 2 mm et une hauteur en saillie du substrat d'au moins 0,5 mm.

5. Procédé selon l'une quelconque des revendications précédentes, dans lequel les ailettes en diamant présentent une conductivité thermique d'au moins 1 W/cmK.

6. Procédé selon la revendication 5, dans lequel le diamant présente une conductivité thermique d'au moins 5 W/cmK.

7. Procédé selon l'une quelconque des revendications précédentes, dans lequel les ailettes en diamant sont enterrées dans le substrat en diamant d'au moins la moitié de la profondeur du substrat.

8. Procédé selon l'une quelconque des revendications précédentes, dans lequel les ailettes en diamant sont constituées de diamant synthétisé en phase gazeuse, de diamant monocristallin synthétisé sous haute pression ou de diamant naturel.

9. Procédé selon la revendication 8, dans lequel les ailettes en diamant sont constituées de diamant polycristallin synthétisé en phase gazeuse présentant une conductivité thermique de 8 à 20 W/cmK, ou de diamant monocristallin synthétisé sous haute pression présentant une conductivité thermique de 15 à 30 W/cmK.
